# EUROPÄISCHE PATENTSCHRIFT

(11) **EP 2 271 784 B1**
(45) Veröffentlichungstag und Bekanntmachung des Hinweises auf die Patenterteilung: **12.06.2013**
(21) Anmeldenummer: 09735751.1
(22) Anmeldetag: 24.04.2009
(51) Int. Cl.: C23C 14/02, C23C 14/54, C23C 10/02, C23C 10/28

(54) **VERFAHREN ZUM DIFFUSIONSVERZINKEN**
SHERARDIZING METHOD
PROCÉDÉ DE SHÉRARDISATION

(30) Priorität: 24.04.2008 DE 102008020576
(43) Veröffentlichungstag der Anmeldung: 12.01.2011
(73) Patentinhaber: Bodycote Wärmebehandlung Gmbh, 73061 Ebersbach (DE); Benteler Automobiltechnik GmbH, 33102 Paderborn (DE)
(72) Erfinder: GRAF, Wolfram, 45133 Essen (DE); NATRUP, Frank, 45549 Sprockhövel (DE); POHL, Martin, 33184 Altenbeken (DE)
(74) Vertreter: Sauer, Philippe
(86) Internationale Anmeldenummer: PCT/EP2009/003029
(87) Internationale Veröffentlichungsnummer: WO 2009/130051

(56) Entgegenhaltungen:
- EP-A- 0 730 045
- WO-A-02/14573
- DE-A1-102005 055 374
- GB-A- 412 989
- GB-A- 2 376 693

## Beschreibung

Die vorliegende Erfindung betrifft ein Verfahren zum Beschichten einer Oberfläche wenigstens eines Substrats mit Zink, welches als Sherardisierverfahren durch geführt wird und bei dem das zu beschichtende Substrat zusammen mit Zink als Beschichtungsmittel bei einer Temperatur zwischen 200 und 500 °C wärmebehandelt wird.

Bauteile aus korrosionsanfälligem Material, wie beispielsweise aus Eisen und Stahl, werden seit langer Zeit verzinkt, d.h. auf ihrer Oberfläche mit einer vergleichsweise dünnen Zinkschicht versehen, um die Korrosionsbeständigkeit der Bauteile zu erhöhen. Beispiele für solche Bauteile sind Verbindungs- und Befestigungselemente, wie Schrauben und Bolzen, Karosserieteile für Kraftfahrzeuge, Leitplanken, Geländer, Außentreppen und dergleichen. Als Verzinkungsverfahren sind beispielsweise das Feuerverzinken, das galvanische Verzinken und das Sherardisieren bekannt.

Beim Feuerverzinken wird das zu beschichtende Substrat nach einer entsprechenden Vorbehandlung, welche herkömmlicherweise die Schritte Entfetten, Beizen, Fluxen und Trocknen umfasst, in eine Zinkschmelze, welche üblicherweise eine Temperatur zwischen 440° bis 460 °C aufweist, eingetaucht und für eine ausreichende Zeit in dieser Schmelze belassen, bevor das so beschichtete Substrat aus der Schmelze entnommen, abgekühlt und ggf. nachbehandelt wird. Ein Nachteil des Feuerverzinkens zeigt sich bei dem Versuch, vergütete hochfeste Stahlteile zu beschichten, denn unter dem Einfluss der relativ hohen Prozesstemperatur von über 450 °C können diese entscheidend an Festigkeit verlieren und dadurch unbrauchbar werden.

Bei der galvanischen Verzinkung erfolgt das Aufbringen der Zinkschicht auf das Verzinkungsgut durch elektrochemische Abscheidung aus einem Zinkelektrolyten. Allerdings ist dieses Verfahren für kompliziert geformte Substrate nur bedingt anwendbar. Ferner dürfen vergütete hochfeste Stahlteile mit diesem Verfahren nicht behandelt werden, um die Gefahr einer Wasserstoffversprödung auszuschließen.

Ein weiteres bekanntes Verzinkungsverfahren ist das Sherardisierverfahren, bei dem das Verzinkungsgut mit Zinkpulver zumeist in Mischung mit einem inerten Material bzw. Füllstoff, wie Sand oder Keramik, beispielsweise Aluminiumoxid oder Siliziumcarbid, bei einer Temperatur zwischen 350 und 415 °C wärmebehandelt wird. Üblicherweise wird das Verfahren in einer beheizbaren rotierenden Trommel durchgeführt, in der das Verzinkungsgut in die Mischung aus Zinkpulver und Füllstoff eingebettet ist, bevor die Trommel nach dem Befüllen luftdicht abgedichtet und auf die erforderliche Temperatur beheizt wird. Der bei dem Sherardisierverfahren eingesetzte Füllstoff hat mehrere Aufgaben. Zum einen sorgt dieser für eine gleichmäßige Erwärmung, für eine sanfte Abreinigung der Bauteile und für eine homogene Verteilung des Zinkpulvers. Zudem verhindert dieser in dem Fall von Schüttgut ein Zusammenschlagen und damit eine Beschädigung der Bauteile. Bei dem Sherardisierverfahren handelt es sich um ein Diffusionsbeschichtungsverfahren, bei dem Zink aus der Dampfphase, welche aufgrund des vergleichsweise hohen Dampfdrucks von Zink bei der bei der Wärmebehandlung eingesetzten Temperatur durch Sublimation gebildet wird, in die Oberflächenschicht des zu verzinkenden Substrats diffundiert. Derartige Verfahren werden beispielsweise in der DE-PS 134 594, in der DE-PS 273 654 und von E.V. Proskurkin & N.S. Gorbunov, "Galvanizing, sherardizing and other zinc diffusion coatings ", Technicopy Limited, England, 1972, Seiten 1 bis 68 beschrieben.

Mit dem Sherardisierverfahren werden selbst bei Einsatz von kompliziert geformten Substraten sehr gleichmäßige, an dem Substrat fest haftende Zinkbeschichtungen mit einer Schichtdicke zwischen 10 und 100 µm erhalten, welche eine hervorragende Korrosionsbeständigkeit aufweisen. Allerdings weisen die bekannten Sherardisierverfahren einige Nachteile auf.

Ein Nachteil der derzeit bekannten Sherardisierverfahren ist der vergleichsweise hohe Zinkverbrauch, der durch das Verbrennen des Zinks in der anfänglich in dem Reaktionsraum vorhandenen Luftatmosphäre mit einer Sauerstoffkonzentration 21 Vol.-% verursacht wird. Zudem sind mit dem Einsatz des Füllstoffs Nachteile verbunden, und zwar sowohl für komplexe Bauteile, die meist in Gestellen in der Trommel fixiert sind, aber auch für den Prozess selbst. Aufgrund des Eigengewichts des Füllstoffs kann es nämlich zu unerwünschten Verformungen des Verzinkungsguts kommen. Ferner wird aufgrund der Wärmekapazität des Füllstoffs für das Verfahren deutlich mehr Heizenergie benötigt, als wenn auf den Füllstoff verzichtet werden würde. Des Weiteren erfordert der Füllstoff zusätzliche Prozessschritte und Handhabungsvorrichtungen. So muss der Füllstoff vor dem Sherardisieren mit in die Trommel zugegeben werden und nachher von dem Beschichtungsgut getrennt und zur Wiederverwendung gereinigt werden. Wenn zur Vermeidung dieser Nachteile auf den Füllstoff verzichtet wird, zeigt sich in der Praxis, dass der Prozess bei üblicher Zinkdosierung nicht mehr zur Schichtbildung führt und somit versagt, oder dass der auf die verzinkte Oberfläche bezogene Zinkverbrauch beträchtlich erhöht ist. Zudem können sich bei einem Verzicht auf die Zugabe von Füllstoff in der Trommel signifikante Mengen von Eisenoxiden bilden, welche für den Beschichtungsprozess unvorteilhaft sind.

In der WO 02/14573 A1 wird ein korrosionsgeschütztes Stahlblech aus kohlenstoffarmem Stahlblech mit einem durch Schmelztauchveredelung, elektrolytische Abscheidung oder physikalische Dampfphasenabscheidung hergestellten Zink- oder Zinklegierungsüberzug offenbart, bei dem in dem Überzug lokal konzentriert Depots aus Metallen oder Legierungen dieser Metalle mit einer die Korrosionsgeschwindigkeit des Zink- oder Zinklegierungsüberzugs herabsetzenden Wirkung enthalten sind. Ferner offenbart diese Druckschrift ein Verfahren zur Herstellung entsprechender Stahlbleche, bei dem ein beidseitig feuerverzinktes Stahlblech unter Vakuum einer Plasmareinigung unterzogen wird, bevor darauf durch Elektronenstrahl- und Vakuumbogenverdampfung eine Magnesiumschicht aufgedampft wird, wonach das so behandelte Stahlblech in einem abgeschlossenen Behälter unter Formiergas mit einem geringen Überdruck auf eine Temperatur von beispielsweise 396°C erhitzt wird.

Aus der GB 2 376 693 A ist ein Verfahren zum Herstellen eines metallischen Materials bekannt, bei dem Magnesium enthaltenes metallisches Material mit Zinkpartikeln durch eine Wärmebehandlung derart behandelt wird, dass das Zink in das Material hinein diffundiert und eine Oberflächenbeschichtung ausbildet, in der Magnesiumatome durch Zink ersetzt sind. Dabei kann die Wärmebehandlung beispielsweise bei einer Temperatur zwischen 310 und 350°C durchgeführt werden.

Aufgabe der vorliegenden Erfindung ist daher die Bereitstellung eines Verfahrens zum Beschichten einer Oberfläche eines Substrats mit Zink, mit dem selbst bei Einsatz von kompliziert geformten Substraten sehr gleichmäßige, an dem Substrat fest haftende Zinkbeschichtungen mit einer hervorragenden Korrosionsbeständigkeit erhalten werden können, welches zudem einen, bezogen auf die Oberfläche des zu verzinkenden Substrates, geringen Zinkverbrauch aufweist und bei dem auf den Einsatz eines Füllstoffs verzichtet werden kann.

Erfindungsgemäß wird diese Aufgabe durch die Bereitstellung eines Verfahrens zum Beschichten einer Oberfläche wenigstens eines Substrats mit Zink gelöst, welches Verfahren als Sherardisierverfahren durchgeführt wird und bei dem das wenigstens eine zu beschichtende Substrat zusammen mit Zink als Beschichtungsmittel bei einer Temperatur zwischen 200 und 500 °C wärmebehandelt wird, wobei vor dem Beginn der Wärmebehandlung in dem Reaktionsraum, in dem das zu beschichtende Substrat wärmebehandelt wird, der Sauerstoffgehalt in der in dem Reaktionsraum enthaltenen Atmosphäre auf weniger gleich 5 Vol.-% eingestellt wird, und dann in dem Reaktionsraum in der so hergestellten Atmosphäre die Wärmebehandlung begonnen wird und die Wärmebehandlung in dem Reaktionsraum durchgeführt wird, wobei während der Wärmebehandlung in den Reaktionsraum kein Gas zugeführt wird oder kein Sauerstoff enthaltendes Gas zugeführt wird oder Gas zugeführt wird, welches so vorbehandelt worden ist, dass es einen Sauerstoffgehalt von maximal 100 ppm enthält, wobei dem Reaktionsraum vor der Wärmebehandlung ein Flussmittel zugeführt wird.

Im Rahmen der vorliegenden Erfindung konnte überraschenderweise herausgefunden werden, dass bei einem Verfahren zum Beschichten einer Oberfläche eines Substrats mit Zink, bei dem das zu beschichtende Substrat zusammen mit Zink als Beschichtungsmittel bei einer Temperatur zwischen 200 und 500 °C wärmebehandelt wird, eine Verzinkung der Oberfläche des Substrats unter Erzeugung einer zu einer hervorragenden Korrosionsbeständigkeit führenden und an dem Substrat fest haftenden Zinkbeschichtung gleichmäßiger Schichtdicke, vorzugsweise zwischen 10 und 100 µm, selbst bei Einsatz eines kompliziert geformten Substrats mit einem, bezogen auf die Oberfläche des zu verzinkenden Substrates, geringen Zinkverbrauch möglich ist, selbst wenn auf den Einsatz eines Füllstoffs verzichtet wird, wenn vor der Wärmebehandlung in dem Reaktionsraum, in dem das zu beschichtende Substrat wärmebehandelt wird, der Sauerstoffgehalt in der in dem Reaktionsraum enthaltenen Atmosphäre auf weniger gleich 5 Vol.-% eingestellt wird, und erst danach in dem Reaktionsraum in der so hergestellten Atmosphäre die Wärmebehandlung begonnen wird und die Wärmebehandlung in dem Reaktionsraum durchgeführt wird, wobei während der Wärmebehandlung in den Reaktionsraum kein Gas zugeführt wird oder kein Sauerstoff enthaltendes Gas zugeführt wird oder ein Gas zugeführt wird, welches so vorbehandelt worden ist, dass es einen Sauerstoffgehalt von maximal 100 ppm enthält. Aufgrund des niedrigeren Zinkverbrauchs können die Verfahrenskosten bei dem erfindungsgemäßen Verfahren verglichen mit den aus dem Stand der Technik bekannten Verfahren um bis zu 40 % verringert werden. Dies liegt nach der Erkenntnis der vorliegenden Erfindung daran, dass der Sauerstoffgehalt in dem Reaktionsraum bei Beginn der Wärmebehandlung weniger als 5 Vol.-% beträgt und danach der Sauerstoffgehalt in dem Reaktionsraum durch das Wärmebehandlungsverfahren weiter verringert wird, ohne dass dem Reaktionsraum nach dem Beginn der Wärmebehandlung von außen weiterer Sauerstoff bzw. maximal Spurenmengen an Sauerstoff zugeführt werden, wohingegen bei den bekannten, im Produktionsmaßstab eingesetzten Sherardisierverfahren die Wärmebehandlung in einem beheizten rotierenden Reaktionsraum erfolgt, welcher nach der in Luftatmosphäre (also in einer 21 % Sauerstoffgehalt enthaltenden Atmosphäre) erfolgenden Beschickung mit dem Verzinkungsgut und der Mischung aus Zinkpulver und Füllstoff abgedichtet wird, bevor der Reaktionsraum auf die erforderliche Temperatur beheizt wird. Indem der Sauerstoffgehalt bei dem erfindungsgemäßen Verfahren bei Beginn der Wärmebehandlung in dem Reaktionsraum maximal 5 Vol.-% beträgt, wird der Restsauerstoff in dem Reaktionsraum verglichen mit den aus dem Stand der Technik bekannten Verfahren, bei denen der Sauerstoffgehalt zu Beginn der Wärmebehandlung etwa 21 Vol.-% beträgt, sehr schnell durch Reaktion des Restsauerstoffs mit dem in dem Reaktionsraum vorhandenen Zink und dem Substrat, welches üblicherweise hohe Mengen an Eisen enthält, durch die bei ca. 200 °C einsetzenden Reaktionen 3 Fe + 2 O₂ → 1 Fe₃O₄ und 2 Zn + O₂ → 2 ZnO umgesetzt, so dass der Sauerstoffgehalt sehr viel schneller als bei den aus dem Stand der Technik bekannten Verfahren auf null oder auf zumindest wenige ppm verringert wird. Da bei dem erfindungsgemäßen Verfahren nach dem Beginn der Wärmebehandlung kein Gas, kein Sauerstoff enthaltendes Gas oder Gas, welches so vorbehandelt worden ist, dass es einen Sauerstoffgehalt von maximal 100 ppm enthält, zugegeben wird, bleibt der durch die vorstehend wiedergegebenen Reaktionen erzeugte Sauerstoffgehalt von 0 Vol.-% bzw. wenigen ppm über die gesamte Dauer der Wärmebehandlung erhalten. Aus diesem Grund wird bei dem erfindungsgemäßen Verfahren verglichen mit den aus dem Stand der Technik bekannten, im Produktionsmaßstab eingesetzten Sherardisierverfahren sehr viel weniger Zink durch die Reaktion mit dem in dem Reaktionsraum befindlichen Sauerstoff verbraucht, weswegen der auf die zu beschichtende Oberfläche des Substrats bezogene Zinkverbrauch geringer ist. Zudem wird dadurch auch nur sehr viel weniger Eisen des Substrats durch die vorstehend wiedergegebene Reaktion zu Eisenoxid umgesetzt, weswegen auf den Zusatz von Füllstoff verzichtet werden kann, ohne dass eine störende Menge an Eisenoxid gebildet wird. Aus diesem Grund kann bei dem erfindungsgemäßen Verfahren auf den Zusatz von Füllstoff verzichtet werden, was zu einer erheblichen Verringerung der Energiekosten für das erfindungsgemäße Verfahren verglichen mit den aus dem Stand der Technik bekannten Verfahren unter Einsatz von Füllstoffen führt.

Der Einsatz von Inertgasen bei Verzinkungsverfahren ist zwar bereits für labortechnische Verfahren von Proskurin & Gorbunov, "Galvanizing, sherardizing and other zinc diffusion coatings", Technicopy Limited, England, 1972, Seiten 45 bis 48, von Pistofidis et al., "Microscopical study of zinc coatings", G.I.T. Imaging & Microscopy, 2005, Seiten 48 bis 50 und von Gorbunov et al., "Zinc diffusion coatings", Zashchita Metallov, Bd. 1, Nr. 3, 1965, Seiten 314 bis 318 beschrieben worden. Bei allen diesen Verfahren wird jedoch das Inertgas während der gesamten Wärmebehandlung kontinuierlich in eine Seite des Reaktionsraums eingeführt und von der gegenüberliegenden Seite des Reaktionsraums abgezogen. Da das Inertgas naturbedingt einen gewissen Sauerstoffgehalt aufweist, wird so während der gesamten Verfahrensdauer ein gewisser Sauerstoffgehalt in dem Reaktionsraum aufrechterhalten. Zudem werden alle diese Verfahren im Pulverpackverfahren durchgeführt. Auf eine zu einem Sauerstoffgehalt von maximal 100 ppm führende Vorbehandlung der Inertgase wird in keiner dieser Druckschriften hingewiesen.

Erfindungsgemäß wird das Verfahren als Diffusionsverfahren bzw. Sherardisierverfahren unter optionaler Verwendung eines Füllstoffs durchgeführt.

Aufgrund des bei dem erfindungsgemäßen Verfahren verringerten Zinkbedarfs pro zu beschichtender Fläche des Substrats wird in Weiterbildung des Erfindungsgedankens wird vorgeschlagen, die Menge des Beschichtungsmittels, also des Zinks, vorzugsweise in Form von Zinkpulver, so zu bemessen, dass das gewünschte Schichtgewicht erreicht wird zuzüglich eines Zinküberschusses, der zum einen durch die innere Oberfläche des Reaktionsraumes, welche sich vor allem aus den Teilflächen des Substrats, der Retortenwand sowie den Einbauten zusammensetzt, und zum anderen durch den Restsauerstoffgehalt in dem Reaktionsraum bestimmt wird. Daraus leitet sich folgende empirisch bestätigte Vorschrift für die Menge des Beschichtungsmittels, also des Zinks, ab: Zum Erreichen des gewünschten Schichtgewichts notwendige Zinkmenge plus Zinküberschussmenge von nicht mehr als 200 g pro 1 m² innerer Oberfläche des Reaktionsraumes plus eine weitere Zinkmenge von nicht mehr als 60 g pro 1 Vol.-% Restsauerstoff und 1 m³ Reaktionsraum. So kann die Menge von nach der Wärmbehandlung in dem Reaktionsraum verbleibendem, nicht umgesetzten Zink, welches von dem Substrat abgetrennt und aufwendig aufbereitet werden muss, um erneut in dem Verfahren eingesetzt zu werden, minimiert werden. Sofern bei dem erfindungsgemäßen Verfahren ein Füllstoff eingesetzt wird, was möglich, aber nicht bevorzugt ist, beträgt das Füllvolumen des Füllstoffs bezogen auf das (geometrische) Volumen des Reaktionsraumes weniger als 60 %, besonders bevorzugt weniger als 10 % und ganz besonders bevorzugt weniger als 1 %. Die bei dieser Ausführungsform eingesetzten Mengen sind so gering, dass das Substrat bzw. die Substrate bei der Wärmebehandlung nicht vollständig in das Zinkpulver bzw. die Mischung aus Zinkpulver und Füllstoff eingebettet oder eingetaucht sind. Bei dieser Ausführungsform handelt es sich somit im Gegensatz zu den derzeit eingesetzten Sherardisierverfahren nicht um ein Pulverpackverfahren, sondern um ein Bestäubungsverfahren. Bei Pulverpackverfahren ist das zu beschichtende Substrat bzw. sind die zu beschichtenden Substrate definitionsgemäß vollständig, d.h. mit ihrer gesamten Oberfläche, in der Mischung aus Zinkpulver und Füllstoff eingebettet.

Grundsätzlich eignet sich das erfindungsgemäße Verfahren zum Verzinken von Substraten, die aus einem mit Zink legierbaren Metall, vorzugsweise aus Eisen und seinen Legierungen, wie beispielsweise Stahl und Gusseisen, aus Kupfer und seinen Legierungen und/oder aus Aluminium und seinen Legierungen bestehen. Das Verfahren erlaubt es ferner, Substrate in einer nahezu unbeschränkten Vielfalt hinsichtlich Form und Größe zu beschichten.

Erfindungsgemäß wird bei dem Verfahren zum Beschichten einer Oberfläche wenigstens eines Substrats mit Zink der Sauerstoffgehalt in der in dem Reaktionsraum enthaltenen Atmosphäre vor dem Beginn der Wärmebehandlung auf weniger gleich 5 Vol.-% eingestellt. Um einen noch niedrigen Zinkverbrauch pro zu beschichtender Substratoberfläche zu erreichen, wird der Sauerstoffgehalt in der in dem Reaktionsraum enthaltenen Atmosphäre vor dem Beginn der Wärmebehandlung vorzugsweise auf weniger gleich 1 Vol.-%, bevorzugter auf weniger gleich 0,5 Vol.-%, besonders bevorzugt auf weniger gleich 0,1 Vol.-%, ganz besonders bevorzugt auf weniger gleich 0,05 Vol.-% und höchst bevorzugt auf weniger gleich 0,01 Vol.-% eingestellt. Die Einstellung des entsprechenden Sauerstoffgehalts vor Beginn der Wärmebehandlung kann beispielsweise durch Spülen des Reaktionsraums mit einem entsprechend wenig oder gar keinen Sauerstoff enthaltenden Gas bzw. Gasgemisch erfolgen oder durch ein- oder mehrmaliges Evakuieren des Reaktorraums und nachfolgendes Belüften des Reaktorraums mit einem entsprechend wenig oder gar keinen Sauerstoff enthaltenden Gas bzw. Gasgemisch erfolgen. Die letztgenannte Variante kann beispielsweise durch zweimaliges Evakuieren des Reaktionsraumes auf einen Druck von 20 mbar durchgeführt, wobei der Reaktionsraum zwischen den einzelnen Evakuierungsschritten mit Inertgas befüllt wird.

Wie bereits dargelegt, wird bei dem erfindungsgemäßen Verfahren der Sauerstoffgehalt in dem Reaktionsraum nach Beginn der Wärmebehandlung durch Reaktion des verbliebenen Restsauerstoffs mit Zink und/oder Eisen auf Spurenmengen, beispielsweise auf 0,1 ppm, verringert, wonach dem Reaktionsraum kein Gas oder maximal geringste Mengen an Sauerstoff enthaltendes Gas zugeführt wird. Besonders gute Ergebnisse werden insbesondere erzielt, wenn dem Reaktionsraum nach dem Beginn der Wärmebehandlung gar kein Gas mehr oder absolut sauerstofffreies Gas zugeführt wird. Allerdings ist es auch, wenn auch weniger bevorzugt, möglich, dem Reaktionsraum Gas zuzuführen, welches so vorbehandelt worden ist, dass es einen Sauerstoffgehalt von maximal 100 ppm enthält. Bei dieser Ausführungsform ist es bevorzugt, wenn der Sauerstoffgehalt des Gases nach der Vorbehandlung maximal 10 ppm, besonders bevorzugt maximal 1 ppm und ganz besonders bevorzugt maximal 0,1 ppm beträgt.

Für die Gasreinigung sind erprobte Adsorptionsverfahren geeignet, die von der Gasindustrie im industriellen Maßstab bereitgestellt werden. Verunreinigungen an Wasserstoff und Sauerstoff können auf diese Weise auf unter 40 bzw. 5 ppb verringert werden.

Sofern dem Reaktionsraum während der Wärmebehandlung Gas zugeführt wird, kann dieses jedes sein, welches gegenüber Zink inert ist, also mit Zink nicht reagiert, wie beispielsweise eines, welches aus der Gruppe ausgewählt wird, welche aus Edelgasen, Stickstoff, Methan, C₁-C₄-Alkanen, C₁-C₄-Alkenen, C₁-C₄-Alkinen, Silanen, Wasserstoff, Ammoniak und beliebigen Kombinationen von zwei oder mehr der vorgenannten Verbindungen besteht.

Wie bereits dargelegt, liegt ein bedeutender Vorteil des erfindungsgemäßen Verfahrens darin, dass bei diesem kein Füllstoff eingesetzt werden muss. Vorzugsweise beträgt daher gemäß einer bevorzugten Ausführungsform der vorliegenden Erfindung das Füllvolumen des Füllstoffs bezogen auf das geometrische Volumen des Reaktionsraumes weniger als 60 %, bevorzugt weniger als 10 % Füllstoff und besonders bevorzugt weniger als 1 %, wobei besonders bevorzugt gar kein Füllstoff eingesetzt wird. Unter Füllstoffen werden hier wärmeleitende Verbindungen, wie beispielsweise Metalloxide, wie Aluminiumoxid, Magnesiumoxid und dergleichen, Sand oder dergleichen verstanden.

In Weiterbildung des Erfindungsgedankens wird vorgeschlagen, in dem erfindungsgemäßen Verfahren als Beschichtungsmittel Zinkpulver mit einem Zinkgehalt zwischen 90 und 100 Gew.-% und vorzugsweise mit einem Zinkgehalt zwischen 99 und 100 Gew.-% einzusetzen.

Vorzugsweise wird Zinkpulver bzw. Zinkstaub mit einer mittleren Korngröße zwischen 3 und 6 µm und einer maximalen Partikelgröße von 70 µm eingesetzt.

Grundsätzlich kann das Beschichtungsmittel dem Reaktionsraum vor oder während der Wärmebehandlung zugeführt werden. Sofern das Beschichtungsmittel dem Reaktionsraum vor der Wärmebehandlung zugeführt wird, ist es bevorzugt, das Substrat zunächst außerhalb des Reaktionsraums mit dem Beschichtungsmittel zu bestäuben oder anderweitig zu beschichten, bevor das so mit Beschichtungsmittel bestäubte Substrat in den Reaktionsraum eingeführt wird und nach Verringerung des Sauerstoffgehalts in dem Reaktionsraum auf maximal 5 Vol.-% die Wärmebehandlung begonnen wird. Ein Vorteil der anderen Ausführungsform, bei der das Beschichtungsmittel dem Reaktionsraum während der Wärmebehandlung zugeführt wird, ist die Möglichkeit, zunächst, d.h. vor Beginn der Wärmebehandlung, mit dem Beschichtungsmittel reaktive Hilfsmittel, nämlich erfindungsgemäß ein Flussmittel, in den Reaktionsraum einzuführen, bevor das Beschichtungsmittel nach Beginn der Wärmebehandlung in den Reaktionsraum eingeführt wird, um so eine Reaktion zwischen diesem Hilfsmittel und dem Beschichtungsmittel vor Beginn der Wärmebehandlung zu verhindern.

Das dem Reaktionsraum erfindungsgemäβ vor der Wärmebehandlung zugeführte Flussmittel wird vorzugsweise aus der Gruppe ausgewählt, welche aus Aluminiumchlorid, Zinkchlorid, Ammoniumchlorid, Calciumchlorid, Chlor, Chlorwasserstoff, Fluorwasserstoff und beliebigen Kombinationen von zwei oder mehr der vorgenannten Verbindungen besteht.

Grundsätzlich kann die Wärmebehandlung bei jedem Druck durchgeführt werden, beispielsweise bei einem leichten Überdrück, wie bei einem Druck in einem Bereich zwischen 1 und 1,5 bar und bevorzugt zwischen 1,02 und 1,2 bar, oder bei einem Unterdruck, wie bei einem Druck in einem Bereich zwischen 10⁻² und 0,99 bar und bevorzugt zwischen 1 und 10 mbar. Während der Vorteil des Arbeitens mit einem Überdruck darin liegt, dass bei etwaigen Undichtigkeiten des Reaktionsraumes keine Luft aus der Umgebung in den Reaktionsraum eindringen kann, wird bei einem Arbeiten mit Unterdruck eine Erhöhung des Diffusionskoeffizienten des Beschichtungsmittels im Gasraum erreicht. Um einen Sauerstoffeintrag über Umgebungsluft bei etwaigen Undichtigkeiten des Reaktionsraumes zu vermeiden, ist es bevorzugt, die Wärmebehandlung bei einem Überdruck durchzuführen.

Auch bezüglich der Temperatur, bei der die Wärmebehandlung durchgeführt wird, ist das erfindungsgemäße Verfahren nicht besonders limitiert. Besonders gute Ergebnisse werden insbesondere erhalten, wenn die Temperatur bei der Wärmebehandlung auf einen Wert in einem Bereich zwischen 300 und 450 °C und besonders bevorzugt zwischen 340 und 400 °C eingestellt wird. Die Dauer der Wärmebehandlung hängt in erster Linie von der bei der Wärmebehandlung eingestellten Temperatur und der gewünschten Schichtdicke der Zinkbeschichtung auf dem Substrat ab. Vorzugsweise wird die Wärmebehandlung für 0,1 bis 24 Stunden und besonders bevorzugt für 0,5 bis 5 Stunden durchgeführt.

Vorzugsweise wird das wenigstens eine mit Zink zu beschichtende Substrat vor dem Beginn der Wärmebehandlung außerhalb des Reaktionsraums gereinigt, bevor dieses in den Reaktionsraum eingeführt wird. Die Reinigung kann durch jedes dem Fachmann zu diesem Zweck bekannte Verfahren erfolgen, wie beispielsweise durch mechanische Oberflächenbehandlung mit einem Strahlmittel, durch Beizen in alkalischen oder sauren Lösungen sowie durch Behandeln mit einem Flussmittel.

Um eine besonders gleichmäßige Beschichtung des wenigstens einen Substrats mit Zink zu erreichen, wird in Weiterbildung des Erfindungsgedankens vorgeschlagen, das wenigstens eine Substrat außerhalb des Reaktionsraums an ein Gestell anzubringen, bevor das Gestell in den Reaktionsraum eingeführt wird. Vorzugsweise wird das Gestell in dem Reaktionsraum drehbar, kippbar, pendelbar, oszilierbar oder vibrierbar angebracht, so dass das Gestell während der Wärmebehandlung in dem Reaktionsraum rotiert, gekippt, gependelt, oszilliert oder vibriert wird.

Gemäß einer weiteren bevorzugten Ausführungsform der vorliegenden Erfindung wird die Wärmebehandlung derart durchgeführt, dass das wenigstens eine Substrat während der Wärmebehandlung auch angelassen wird.

Um eine optimale Verfahrensführung zu gewährleisten, wird in Weiterbildung des Erfindungsgedankens vorgeschlagen, in dem Reaktionsraum während der Wärmebehandlung den Druck, die Temperatur und den Sauerstoffgehalt zu messen und zu steuern.

Ferner ist es bevorzugt, das Beschichtungsmittel während der Wärmebehandlung in dem Reaktionsraum durch Aufstäuben und Umwälzen zu verteilen. Auf diese Weise kann auf dem Substrat eine Zinkbeschichtung mit besonders gleichmäßiger Schichtdicke erhalten werden.

Zudem ist es bevorzugt, das unverbrauchte Beschichtungsmittel und den Abbrand bzw. das unverbrauchte Beschichtungsmittel nach der Wärmebehandlung aus dem Reaktionsraum zu entfernen und den unverbrauchten Teil bei einer späteren Verfahrensdurchführung wiederzuverwerten.

In Abhängigkeit von dem späteren Verwendungszweck des beschichteten Substrats kann es vorteilhaft sein, das beschichtete Substrat nach der Wärmebehandlung zu passivieren. Dabei können alle dem Fachmann bekannten Passivierungsverfahren angewendet werden, wie beispielsweise Phosphatpassivierung, Chrompassivierung und Carbonatpassivierung.

Ein weiterer Gegenstand der vorliegenden Erfindung ist ein wie zuvor beschrieben durchgsfürtes Verfahren zum Beschichten einer Oberfläche wenigstens eines Substrats mit Zink, bei dem das wenigstens eine zu beschichtende Substrat zusammen mit Zink als Beschichtungsmittel bei einer Temperatur zwischen 200 und 500 °C wärmebehandelt wird, wobei dieses Verfahren in einer Vorrichtung durchgeführt wird, welche einen stationären Ofen umfasst, in dessen Inneren ein verschließbarer, stationärer Reaktionsraum vorgesehen ist, wobei in dem Reaktionsraum wenigstens ein drehbar, kippbar, pendelbar, oszilierbar oder vibrierbar angeordnetes Gestell vorgesehen ist, welches so ausgestaltet ist, dass in diesem wenigstens ein Substrat befestigt werden kann, und wobei der Sauerstoffgehalt der in dem Reaktionsraum enthaltenen Atmosphäre vor dem Beginn der Wärmebehandlung auf weniger gleich 5 Vol.-% eingestellt wird.

Diese Verfahrensführung ist deshalb bevorzugt, weil ein stationärer Ofen, in dessen Inneren ein verschließbarer, stationärer Reaktionsraum vorgesehen ist, im Unterschied zu den Vorrichtungen, in denen die bekannten Sherardisierverfahren im Produktionsmaßstab durchgeführt werden, nämlich drehbaren Trommelöfen, hervorragend abdichtbar ist und so bei der Durchführung der Wärmebehandlung ein Eindringen von den Ofen umgebender Luft in den Reaktionsraum zuverlässig verhindert werden kann, auch wenn während der Wärmebehandlung in dem Reaktionsraum kein Überdruck eingestellt wird. Aus diesem Grund werden in dieser Vorrichtung vorzugsweise alle wesentlichen Dichtungen außerhalb des Reaktionsraums vorgesehen.

Eine drehbare Anordnung des Gestells in dem Reaktionsraum kann beispielsweise über zwischen der Wand des Reaktionsraums und dem Gestell angeordnete Rollen oder Walzen erreicht werden.

Vorzugsweise weist die Vorrichtung zudem einen Injektor auf, welcher so ausgestaltet ist, dass über diesen Zinkpulver und/oder ein Gas bzw. Gasgemisch in den verschlossenen Reaktionsraum eingeführt werden kann.

In Weiterbildung des Erfindungsgedankens wird vorgeschlagen, in dem Reaktionsraum ein Druckmessgerät, ein Temperaturmessgerät und/oder ein Sauerstoffmessgerät vorzusehen, um so bei der Durchführung des Verfahrens den Druck, die Temperatur und/oder den Sauerstoffgehalt messen und steuern zu können.

Ferner kann die Vorrichtung zudem eine Abreinigung aufweisen, welche so ausgestaltet ist, dass die Pulverstäube aus dem Reaktionsraum entfernt werden können.

Nachfolgend wird die vorliegende Erfindung rein beispielhaft anhand vorteilhafter Ausführungsformen und unter Bezugnahme auf die beigefügte Zeichnung beschrieben.

Dabei zeigt die:

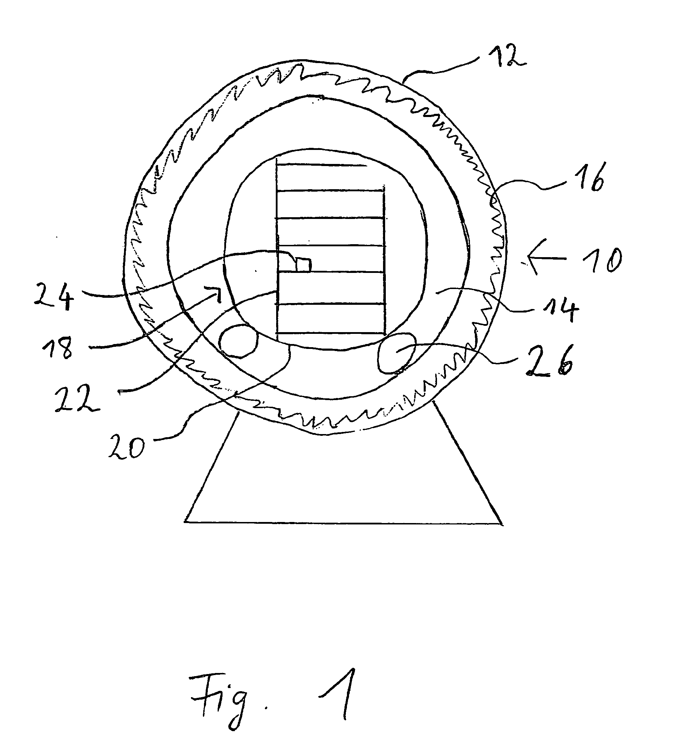

- Figur 1: eine schematische Ansicht einer zur Durchführung des erfindungsgemäßen Verfahrens geeigneten Vorrichtung gemäß eines Ausführungsbeispiels der vorliegenden Erfindung.

Die in der Figur 1 dargestellte Vorrichtung 10 umfasst einen im Wesentlichen zylindrisch ausgestalteten stationären Ofen 12, in dessen Inneren ein ebenfalls im Wesentlichen zylindrisch ausgestalteter verschließbarer, stationärer Reaktionsraum 14 vorgesehen ist, welcher umfangsseitig und an der Rückseite durch Wände vollständig umschlossen ist und an dessen Vorderseite (nicht dargestellt) eine verschließbare Tür angebracht ist. Zur Beheizung des Reaktionsraums 14 ist zwischen der Wand des Reaktionsraums 14 und der äußeren Wand des Ofens 12 ein Heizelement 16 vorgesehen.

In dem Inneren des Reaktionsraums 14 ist ein Gestell 18 angeordnet, welches aus einem Gestellmantel 20, welcher als ein an seinen beiden Stirnseiten offener Hohlzylinder 20 ausgebildet ist, sowie einem an dem Gestellmantel befestigten Gestellträger 22 besteht. In dem Gestellträger 22 sind mehrere Substrate 24, von denen in der Figur 1 nur eines dargestellt ist, angeordnet und befestigt.

Zwischen der umfangsseitigen Wand des Reaktionsraums 14 und dem Gestellmantel 20 sind zwei Rollen 26 vorgesehen, auf denen das Gestell 18 drehbar gelagert ist. Zudem ist an der Tür des Reaktionsraums 14 ein Injektor (nicht dargestellt) vorgesehen, über den in den Reaktionsraum 14 Beschichtungsmittel eingebracht werden kann.

Alle wesentlichen Dichtungen (nicht dargestellt) des Ofens 12 sind außerhalb des Reaktionsraums 14 angeordnet, weswegen der Ofen 12 luftdicht abgeschlossen werden kann.

Zur Durchführung des Verfahrens gemäß eines Ausführungsbeispiels der vorliegenden Erfindung werden die zu beschichtenden Substrate 24 zunächst außerhalb des Ofens 12 vorzugsweise in Strahlanlagen gründlich gereinigt und anschließend an dem Gestellträger 22 des Gestells 18 befestigt. Daraufhin wird das bestückte Gestell 18 durch die Tür in den Reaktionsraum 14 eingeführt und auf den Rollen 26 drehbar platziert, bevor die Tür geschlossen und der Reaktionsraum 14 somit gasdicht verschlossen wird.

Anschließend wird der Reaktionsraum 14 auf einen Druck von beispielsweise 150 mbar evakuiert und dieser anschließend mit sauerstofffreiem Stickstoff befüllt. Dieser Vorgang wird dreimal wiederholt, um den Sauerstoffgehalt in der in dem Reaktionsraum 14 befindlichen Atmosphäre auf einen Wert von unter 1 Vol.-% abzusenken. Bei dem letzten Befüllen des Reaktionsraums 14 mit sauerstofffreiem Stickstoff wird der Druck in dem Reaktionsraum 14 auf einen Überdruck von beispielsweise 1,3 bar eingestellt.

Danach wird der Reaktionsraum 14 über das Heizelement 16 auf eine Temperatur von 400 °C beheizt, um die Wärmebehandlung zu beginnen. Während der Aufheizzeit wird in den Reaktionsraum 14 über den Injektor Beschichtungsmittel in Form von Zinkpulver eingeführt, und zwar in einer Menge, die so bemessen wird, dass das gewünschte Schichtgewicht erreicht wird zuzüglich eines Zinküberschusses, der bezogen auf 1 m³ des Reaktionsraumes nicht mehr als 2 kg beträgt. Während der Wärmebehandlung wird das Gestell 18 in dem Reaktionsraum 14 über die Walzen 26 kontinuierlich gedreht. Zusätzlich dazu kann das Beschichtungsmittel über ein in dem Reaktionsraum 14 angeordnetes Gebläse (nicht dargestellt) ständig umgewälzt werden. Die Wärmebehandlung wird für beispielsweise 2 Stunden nach Erreichen der Betriebstemperatur von 400 °C durchgeführt.

Nach Beendigung der Wärmebehandlung wird der Reaktionsraum 14 abgekühlt und das verbleibende Beschichtungsmittel von der Oberfläche der Substrate 24 mit Hilfe einer Gasentstaubungsvorrichtung entfernt, bevor das Gestell 18 zum Entladen der Substrate aus dem Reaktionsraum 14 entnommen wird. Ein Teil des Beschichtungsmittels kann in der nachfolgenden Charge wiederverwendet werden.

### Bezugszeichenliste

| | |
|---|---|
| 10 | Vorrichtung zur Verzinkung |
| 12 | stationärer Ofen |
| 14 | stationärer Reaktionsraum |
| 16 | Heizelement |
| 18 | Gestell |
| 20 | Gestellmantel |
| 22 | Gestellträger |
| 24 | Substrat |
| 26 | Rollen |

## Patentansprüche

1. Verfahren zum Beschichten einer Oberfläche wenigstens eines Substrats mit Zink, welches als Sherardisierverfahren durchgeführt wird, bei dem das wenigstens eine zu beschichtende Substrat zusammen mit Zink als Beschichtungsmittel bei einer Temperatur zwischen 200 und 500 °C wärmebehandelt wird und vor dem Beginn der Wärmebehandlung in dem Reaktionsraum, in dem das zu beschichtende Substrat wärmebehandelt wird, der Sauerstoffgehalt in der in dem Reaktionsraum enthaltenen Atmosphäre auf weniger gleich 5 Vol.-% eingestellt wird, und dann in dem Reaktionsraum in der so hergestellten Atmosphäre die Wärmebehandlung begonnen wird und die Wärmebehandlung in dem Reaktionsraum durchgeführt wird, wobei während der Wärmebehandlung in den Reaktionsraum kein Gas zugeführt wird oder kein Sauerstoff enthaltendes Gas zugeführt wird oder ein Gas zugeführt wird, welches so vorbehandelt worden ist, dass es einen Sauerstoffgehalt von maximal 100 ppm enthält,
**dadurch gekennzeichnet, dass**
dem Reaktionsraum vor der Wärmebehandlung ein Flussmittel zugeführt wird.

2. Verfahren nach Anspruch 1,
**dadurch gekennzeichnet, dass**
die Wärmebehandlung bei einer Temperatur zwischen 340 und 400 °C durchgeführt wird.

3. Verfahren nach Anspruch 1 oder 2,
**dadurch gekennzeichnet, dass**
das Substrat aus einem mit Zink legierbaren Metall, vorzugsweise aus Eisen und seinen Legierungen, wie beispielsweise Stahl und Gusseisen, aus Kupfer und seinen Legierungen und/oder aus Aluminium und seinen Legierungen besteht.

4. Verfahren nach zumindest einem der vorstehenden Ansprüche,
**dadurch gekennzeichnet, dass**
vor dem Beginn der Wärmebehandlung in dem Reaktionsraum, in dem das zu beschichtende Substrat wärmebehandelt wird, der Sauerstoffgehalt in der in dem Reaktionsraum enthaltenen Atmosphäre auf weniger gleich 1 Vol.-%, vorzugsweise auf weniger gleich 0,5 Vol.-%, bevorzugter auf weniger gleich 0,1 Vol.-%, besonders bevorzugt auf weniger gleich 0,05 Vol.-% und ganz besonders bevorzugt auf weniger gleich 0,01 Vol.-% eingestellt wird.

5. Verfahren nach zumindest einem der vorstehenden Ansprüche,
**dadurch gekennzeichnet, dass**
in dem Reaktionsraum während der Wärmebehandlung kein Füllstoff vorliegt oder, bezogen auf das Volumen des Reaktionsraumes weniger als 60 % Füllstoff, bevorzugt weniger als 10 % Füllstoff und besonders bevorzugt weniger als 1 % Füllstoff vorliegen.

6. Verfahren nach zumindest einem der vorstehenden Ansprüche,
**dadurch gekennzeichnet, dass**
das zu beschichtende Substrat vor dem Beginn der Wärmebehandlung außerhalb des Reaktionsraums mit Beschichtungsmittel bestäubt oder beschichtet wird.

7. Verfahren nach zumindest einem der vorstehenden Ansprüche,
**dadurch gekennzeichnet, dass**
das dem Reaktionsraum vor der Wärmebehandlung zugeführte Flussmittel aus der Gruppe ausgewählt wird, welche aus Aluminiumchlorid, Zinkchlorid, Ammoniumchlorid, Calciumchlorid, Chlor, Chlorwasserstoff, Fluorwasserstoff und beliebigen Kombinationen von zwei oder mehr der vorgenannten Verbindungen besteht.

8. Verfahren nach zumindest einem der vorstehenden Ansprüche,
**dadurch gekennzeichnet, dass**
das wenigstens eine Substrat außerhalb des Reaktionsraums an ein drehbares Gestell angebracht wird, bevor das Gestell in den Reaktionsraum eingeführt wird.

9. Verfahren nach Anspruch 8,
**dadurch gekennzeichnet, dass**
das Gestell während der Wärmebehandlung in dem Reaktionsraum rotiert, gekippt, gependelt, oszilliert oder vibriert wird.

10. Verfahren nach zumindest einem der vorstehenden Ansprüche,
**dadurch gekennzeichnet, dass**
die Wärmebehandlung derart durchgeführt wird, dass das wenigstens eine Substrat während der Wärmebehandlung auch angelassen wird.

11. Verfahren nach zumindest einem der vorstehenden Ansprüche,
**dadurch gekennzeichnet, dass**
das Beschichtungsmittel während der Wärmebehandlung in dem Reaktionsraum durch Aufstäuben und Umwälzen verteilt wird.

12. Verfahren nach zumindest einem der vorstehenden Ansprüche,
**dadurch gekennzeichnet, dass**
das beschichtete Substrat nach der Wärmebehandlung passiviert wird.

13. Verfahren zum Beschichten einer Oberfläche wenigstens eines Substrats mit Zink, bei dem das wenigstens eine zu beschichtende Substrat zusammen mit Zink als Beschichtungsmittel bei einer Temperatur zwischen 200 und 500 °C wärmebehandelt wird, nach einem der Ansprüche 1 bis 12,
**dadurch gekennzeichnet, dass**
es in einer Vorrichtung (10) durchgeführt wird, welche einen stationären Ofen (12) umfasst, in dessen Inneren ein verschließbarer, stationärer Reaktionsraum (14) vorgesehen ist, wobei in dem Reaktionsraum (14) wenigstens ein drehbar, kippbar, pendelbar, oszilierbar oder vibrierbar angeordnetes Gestell (18) vorgesehen ist, welches so ausgestaltet ist, dass in diesem wenigstens ein Substrat (24) befestigt werden kann, und, dass der Sauerstoffgehalt der in dem Reaktionsraum (14) enthaltenen Atmosphäre vor dem Beginn der Wärmebehandlung auf weniger gleich 5 Vol.-% eingestellt wird.

14. Verfahren nach Anspruch 13,
**dadurch gekennzeichnet, dass**
die Vorrichtung (10) zudem einen Injektor aufweist, welcher so ausgestaltet ist, dass über diesen Zinkpulver und/oder ein Gas bzw. Gasgemisch in den verschlossenen Reaktionsraum (14) eingeführt werden kann.

15. Verfahren nach Anspruch 13 oder 14,
**dadurch gekennzeichnet, dass**
die Vorrichtung (10) zudem eine Abreinigung aufweist, welche so ausgestaltet ist, dass die Pulverstäube aus dem Reaktionsraum (14) entfernt werden können.

## Claims

1. A method for the coating of a surface of at least one substrate with zinc which is carried out as a Sherardizing process, wherein the at least one substrate to be coated is heat treated together with zinc as a coating agent at a temperature between 200 and 500°C and wherein before the start of the heat treatment in the reaction space in which the substrate to be coated is heat treated, the oxygen content in the atmosphere contained in the reaction space is set to less than or equal to 5 volume percent and the heat treatment is then started in the atmosphere produced in this manner in the reaction space and the heat treatment is carried out in the reaction space, with no gas being supplied into the reaction space during the heat treatment or with no gas containing oxygen being supplied or with a gas being supplied which has been pretreated so that it contains an oxygen content of a maximum of 100 ppm, **characterized in that**
a flux agent is supplied to the reaction space before the heat treatment.

2. A method in accordance with claim 1,
**characterized in that**
the heat treatment is carried out at a temperature between 300 and 450°C.

3. A method in accordance with claim 1 or claim 2,
**characterized in that**
the substrate is made of a metal which can be alloyed with zinc, preferably of iron and its alloys such as steel and cast iron, of copper and its alloys and/or of aluminum and its alloys.

4. A method in accordance with at least one of the preceding claims,
**characterized in that**
before the start of the heat treatment in the reaction space in which the substrate to be coated is heat treated, the oxygen content in the atmosphere contained in the reaction space is set to less than or equal to 1 volume percent, preferably to less than or equal to 0.5 volume percent, more preferably to less than or equal to 0.1 volume percent, particularly preferably to less than or equal to 0.05 volume percent and very particularly preferably to less than or equal to 0.01 volume percent.

5. A method in accordance with at least one of the preceding claims,
**characterized in that**
no filler is present in the reaction space during the heat treatment or, with respect to the volume of the reaction space, less than 60% of filler, preferably less than 10% of filler and particularly preferably less than 1% of filler is present.

6. A method in accordance with at least one of the preceding claims,
**characterized in that**
the substrate to be coated is dusted or coated with coating agent outside the reaction space before the start of the heat treatment.

7. A method in accordance with at least one of the preceding claims,
**characterized in that**
the flux agent supplied to the reaction space before the heat treatment is selected from the group which comprises aluminum chloride, zinc chloride, ammonium chloride, calcium chloride, chlorine, hydrogen chloride, hydrogen fluoride and any desired combinations of two or more of the aforesaid compounds.

8. A method in accordance with at least one of the preceding claims,
**characterized in that**
the at least one substrate is attached to a rotatable rack outside the reaction space before the rack is introduced into the reaction space.

9. A method in accordance with claim 8,
**characterized in that**
the rack is rotated, tilted, swung, oscillated or vibrated during the heat treatment in the reaction space.

10. A method in accordance with at least one of the preceding claims,
**characterized in that**
the heat treatment is carried out such that the at least one substrate is also annealed during the heat treatment.

11. A method in accordance with at least one of the preceding claims,
**characterized in that**
the coating agent is distributed in the reaction space by sputtering and circulating during the heat treatment.

12. A method in accordance with at least one of the preceding claims,
**characterized in that**
the coated substrate is passivated after the heat treatment.

13. A method for the coating of a surface of at least one substrate with zinc, wherein the at least one substrate to be coated is heat treated together with zinc as a coating agent at a temperature between 200 and 500°C, in accordance with any one of the claims 1 to 12,
**characterized in that**
it is carried out in an apparatus (10) which comprises a stationary furnace (12) in whose interior a closable, stationary reaction space (14) is provided, with at least one rack (18) being provided arranged in a rotatable, tiltable, swingable, oscillatable or vibratable manner in the reaction space (14) and made such that at least one substrate (24) can be fastened in it; and **in that** the oxygen content of the atmosphere contained in the reaction space (14) is set to less than or equal to 5 volume percent before the start of the heat treatment.

14. A method in accordance with claim 13,
**characterized in that**
the apparatus (10) moreover has an injector which is configured such that zinc powder and/or a gas or a gas mixture can be introduced into the closed reaction space (14) via it.

15. A method in accordance with claim 13 or claim 14,
**characterized in that**
the apparatus (10) moreover has a cleaning which is configured such that the powder dust can be removed from the reaction space (14).

## Revendications

1. Procédé pour le revêtement d'une surface d'au moins un substrat avec du zinc, qui est exécuté comme un procédé de shérardisation, dans lequel ledit au moins un substrat à revêtir est traité à chaud conjointement avec du zinc à titre d'agent de revêtement à une température entre 200 et 500° C et avant le commencement du traitement à chaud, dans la chambre de réaction dans laquelle le substrat à revêtir est traité à chaud, la teneur en oxygène de l'atmosphère contenue dans la chambre de réaction est établie à une valeur inférieure ou égale à 5 % en volume, et on commence alors le traitement à chaud dans la chambre de réaction dans l'atmosphère ainsi établie et l'on exécute le traitement à chaud dans la chambre de réaction, dans lequel pendant le traitement à chaud on n'introduit aucun gaz dans la chambre de réaction ou on n'introduit aucun gaz contenant de l'oxygène, ou bien on introduit un gaz qui a été préalablement traité de telle manière qu'il contient une teneur en oxygène au maximum de 100 ppm,
**caractérisé en ce que** l'on admet un agent de flux dans la chambre de réaction avant le traitement à chaud.

2. Procédé selon la revendication 1,
**caractérisé en ce que** le traitement à chaud est exécuté à une température entre 340 et 400 ° C.

3. Procédé selon la revendication 12,
**caractérisé en ce que** le substrat est en un métal susceptible d'être allié avec du zinc, de préférence en fer et ses alliages, comme par exemple en acier et en fer de fonderie, en cuivre et ses alliages et/ou en aluminium et ses alliages.

4. Procédé selon l'une au moins des revendications précédentes,
**caractérisé en ce que**, avant le commencement du traitement à chaud, dans la chambre de réaction dans laquelle le substrat à revêtir est traité à chaud, la teneur en oxygène dans l'atmosphère contenue dans la chambre de réaction est établie à une valeur inférieure ou égale à 1 % en volume, de préférence inférieure ou égale à 0,5 % en volume, de préférence inférieure ou égale à 0,1 % en volume, de manière particulièrement préférée inférieure ou égale à 0,05 % en volume, et de manière tout à fait préférée inférieure ou égale à 0,01 % en volume.

5. Procédé selon l'une au moins des revendications précédentes,
**caractérisé en ce que** pendant le traitement à chaud il n'existe aucune matière de remplissage dans la chambre de réaction ou bien, par référence au volume de la chambre de réaction, il existe moins de 60 % de matière de remplissage, de préférence moins de 10 % de matière de remplissage, et de manière particulièrement préférée moins de 1 % de matière de remplissage.

6. Procédé selon l'une au moins des revendications précédentes,
**caractérisé en ce que**, avant le commencement du traitement à chaud, le substrat à revêtir est pulvérisé ou revêtu avec un agent de revêtement.

7. Procédé selon l'une au moins des revendications précédentes,
**caractérisé en ce que** l'agent de flux admis dans la chambre de réaction avant le traitement à chaud est choisi parmi le groupe constitué de chlorure d'aluminium, chlorure de zinc, chlorure d'ammonium, chlorure de calcium, chlore, hydrure de chlore, hydrure de fluor, et des combinaisons quelconques de deux ou plusieurs des composés précités.

8. Procédé selon l'une au moins des revendications précédentes,
**caractérisé en ce que** ledit au moins un substrat est monté à l'extérieur de la chambre de réaction sur un support rotatif, avant d'introduire le support dans la chambre de réaction.

9. Procédé selon la revendication 8,
**caractérisé en ce que** pendant le traitement à chaud le support est mis en rotation, basculé, mis en mouvement pendulaire, mis en oscillation ou en vibration dans la chambre de réaction.

10. Procédé selon l'une au moins des revendications précédentes,
**caractérisé en ce que** le traitement à chaud est exécuté de telle façon que ledit au moins un substrat est également recuit pendant le traitement à chaud.

11. Procédé selon l'une au moins des revendications précédentes,
**caractérisé en ce que** l'agent de revêtement est réparti dans la chambre de réaction pendant le traitement à chaud par pulvérisation et recirculation.

12. Procédé selon l'une au moins des revendications précédentes,
**caractérisé en ce que** le substrat revêtu est passivé après le traitement à chaud.

13. Procédé pour revêtir une surface d'au moins un substrat avec du zinc, dans lequel ledit au moins un substrat à revêtir est traité à chaud conjointement avec du zinc à titre d'agent de revêtement à une température entre 200 et 500° C, selon l'une des revendications 1 à 12,
**caractérisé en ce que** le procédé est mis en oeuvre dans un appareil (10) qui comprend un four stationnaire (12) à l'intérieur duquel il est prévu une chambre de réaction stationnaire (14) susceptible d'être fermée, dans lequel au moins un support (18) agencé avec possibilité de rotation, de basculement, de mouvement pendulaire, de mouvement oscillatoire ou vibratoire est prévu dans la chambre de réaction (14), le support étant conçu de telle manière qu'au moins un substrat (24) peut être fixé dans ce support, et **en ce que** la teneur en oxygène de l'atmosphère contenue dans la chambre le réaction (14) est établie avant le commencement du traitement à chaud à une valeur inférieure ou égale à 5 % en volume.

14. Procédé selon la revendication 13,
**caractérisé en ce que** l'appareil (10) comprend en outre un injecteur qui est conçu de telle manière que de la poudre de zinc et/ou un gaz ou encore un mélange gazeux peut être introduit(e) dans la chambre de réaction (14) fermée via cet injecteur.

15. Procédé selon la revendication 13 ou 14,
**caractérisé en ce que** l'appareil (10) comprend en outre un dispositif de nettoyage qui est conçu de telle manière que les pulvérisations de poudre peuvent être enlevées hors de la chambre de réaction (14).
